# EUROPEAN PATENT SPECIFICATION

(11) **EP 0 250 161 B1**
(45) Date of publication and mention of the grant of the patent: **04.10.2000**
(21) Application number: 87305165.0
(22) Date of filing: 11.06.1987
(51) Int. Cl.: H01L 21/316, H01L 21/20

(54) **Method of manufacturing devices including a semiconductor/dielectric interface**
Herstellungsmethode für Anordnungen mit einem Halbleiter-/dielektrischen Interface
Méthode de fabrication de dispositifs comprenant un interface semi-conducteur diélectrique

(30) Priority: 18.06.1986 US 875641; 19.03.1987 US 27708
(43) Date of publication of application: 23.12.1987
(73) Proprietor: AT&T Corp., New York, NY 10013-2412 (US)
(72) Inventor: Bevk, Joze, Berkeley Heights New Jersey 07922 (US); Feldman, Leonard Cecil, Berkeley Heights New Jersey 07922 (US); Ourmazd, Abbas, Middletown New Jersey 07748 (US)
(74) Representative: Watts, Christopher Malcolm Kelway, Dr.

(56) References cited:
- PHYSICAL REVIEW LETTERS, Vol. 56, No. 4, 27 January 1986, p. 355-358, New York, US; J.M. Gibson et al.: "Preservation of a 7 x 7 Periodicity at a Buried Amorphous-Si/Si(111) Interface"
- International Electron Device Meeting, Washington, D.C, 7-9 Dec. 1981, p. 710-711; IEEE, New York, USA; N.S. Saks: "Reduction of interface state Density in NMOS Capacitors by Hydrogen Implantation."
- PATENT ABSTRACTS OF JAPAN, Vol. 7, No. 65, (E-165), Mars 18, 1983 & JP-A-57 211 238 (NIPPON DNEKI KK) 25-12-1982

## Description

### Technical Field

The invention is concerned with semiconductor devices and their manufacture.

### Background of the Invention

As semiconductor technology continues to develop in terms of novel devices, increased device performance, and higher packing densities, there is increasing demand for improved structures and materials not only with respect to semiconductor materials proper, but also with respect to conductor and insulator materials and their mutual interfaces. Typical examples of such materials and interfaces are metallization materials and their contact interface with semiconductor materials, insulating layers such as, e.g., gate insulating layers, and passivating layers such as, e.g., interdiffusion barrier layers.

Surface and interface structure is of interest in semiconductor device technology, e.g., as motivated by the desire to minimize the number of defect states (i.e., of the so-called trap density) at an interface between two different materials. For example, in silicon device technology, defect states are of concern at the interface between silicon material on the one hand and, on the other, with native oxide which forms upon exposure of a silicon surface to oxygen. Minimization of defect states often enhances the uniformity and reliability of device performance even under conditions of extreme device miniaturization and high-speed operation as desired in communications and computing device technology.

In view of the current preeminence of silicon-based semiconductor device technology, it is readily appreciated that surface structures of silicon, silicon alloys, and silicon compounds have been studied intensively and, as a result, a number of surface structure configurations have been investigated and discussed in the literature. For example, with respect to bulk silicon surfaces, a so-called 7 x 7 reconstruction has been observed and analyzed; see, e.g.,
E.G. McRae, "Surface Stacking Sequence and (7 x 7) Reconstruction at Si(111) Surfaces", Physical Review B, Vol. 28 (1983), pp. 2305-2307;
K. Takayanagi et al., "Structural Analysis of Si(111)-7x7 by UHV-transmission Electron Diffraction and Microscopy", Journal of Vacuum Science and Technology A, Vol. 3 (1985_, pp. 1502-1506; and
J.C. Phillips, "New Model for Reconstructed Si(111) 7 x 7 Surface Superlattices", Physical Review Letters, Vol.45 (1980), pp. 905-908.

A 7 x 7 reconstruction has also been observed at germanium surfaces, and a 5 x 5 reconstruction has been observed at a free surface of a Si-Ge alloy grown on silicon as reported by
H.-J. Gossmann et al., "7 x 7 Reconstruction of Ge(111) Surfaces under Compressive Strain", Physical Review Letter, Vol. 55 (1985), pp. 1106-1109 and
H.-J. Gossmann et al., "Observation of a (5 x 5) LEED Pattern from GeₓS₁₋ₓ(111) Alloys", Surface Science, Vol. 138 (1984), pp. L175-L180.

Concerning an interface between amorphous and single-crystal silicon it was found that 7 x 7 reconstruction of the single-crystal silicon is preserved upon deposition of amorphous silicon; see
J.M. Gibson et al., "Preservation of a 7 x 7 Periodicity at a Buried Amorphous-Si/Si(111) Interface", Physical Review Letters, Vol. 56. pp. 355-358.
Patent Abstracts of Japan, Vol. 7. No. 65 (E-165), 1983 describes a MIS device comprising a III-V semiconductor substrate on which a silicon dioxide dielectric layer is formed. A layer of silicon from 1 to 5 monolayers thick is interposed between the substrate and the dielectric layer.

While the references cited above are concerned with reconstruction at free surfaces or at a silicon/silicon interface, particular attention is paid in the following to the quality of interfaces between different materials and, in particular, of interfaces between a semiconductor material and a dielectric compound material. Ordering in a dielectric material at an interface is of considerable practical interest because it is believed that such ordering results in low density of defect states. Such ordering had not been observed.

### Summary of the Invention

An ordered dielectric containing a Group IV element at least one monolayer thick is produced on a Group IV semiconductor material as a result of suitable surface ordering of the semiconductor material at the semiconductor-dielectric interface. At least Group IV element in the dielectric compound is the same as the Group IV semiconductor material. Compounds of interest include at least one Group IV semiconductor constituent element as, e.g., in the case of silicon oxide or silicon nitride on a surface of doped or undoped silicon. Ordering of interest is on an atomic scale and involves periodicity in the spacing of semiconductor and dielectric constituent atoms; as a result of ordering, interface quality is modified as compared with an interface involving a disordered compound.

Desired ordering of the semiconductor material can be induced by surface strain. Tensile strain can be produced upon growth of a silicon layer on a relaxed silicon-germanium layer; such strain can be induced also by low-temperature annealing of an interface structure.

Alternatively, desired ordering can be obtained in the absence (or virtual absence) of strain at the semiconductor/dielectric interface as, e.g., in the case of an ordered silicon oxide on a (100)-silicon substrate.

### Brief Description of the Drawing

FIG. 1 is a schematic, cross-sectional view of a device structure in accordance with an embodiment of the invention;
FIG. 2 is a schematic cross-sectional view of an n-channel metal-oxide semiconductor device comprising a silicon/silicon oxide interface structure representing an embodiment of the invention; and
FIG. 3 is a schematic representation of a diffraction pattern as has been observed by transmission electron diffraction examination of an embodiment of interface structure in accordance with the invention.
FIG. 4 is an actual lattice image, obtained in cross section, of an altenate embodiment of interface structure in accordance with the invention; and
FIG. 5 is an actual lattice image, obtained in cross section and perpendicular to the image of FIG. 4, of the same alternate embodiment of interface structure in accordance with the invention.

### Detailed Description

Description of the invention involves reference to order on an atomic scale in compound and semiconductor layers, order being defined in terms of so-called reconstruction, i.e., structure or atomic periodicity different from bulk structure at a material surface or interface. Reconstruction can be determined by a number of diffraction techniques such as, e.g., low-energy electron diffraction (LEED), reflection high-energy electron diffraction (RHEED), and transmission electron diffraction (TED), the latter being particularly suited for the study not only of free surfaces but also of buried interfaces.

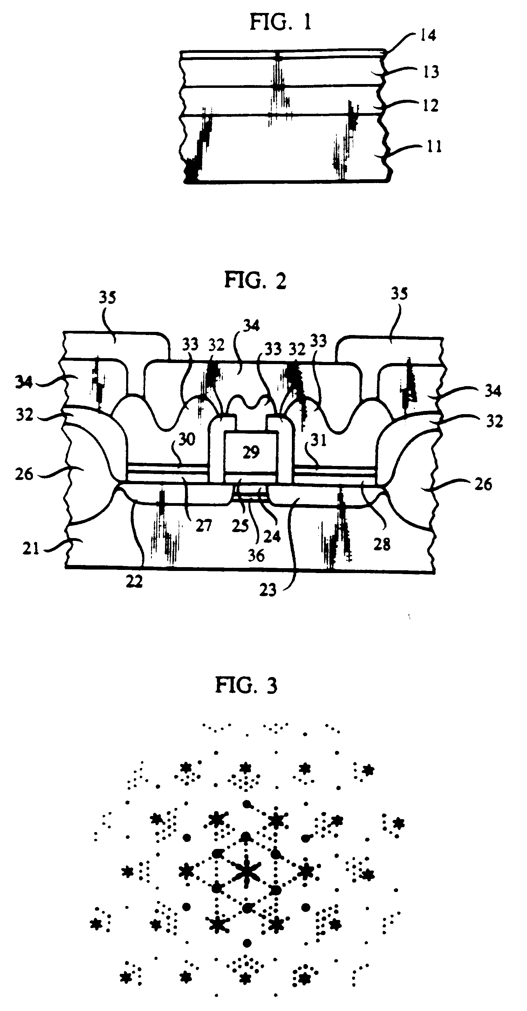

FIG. 1 shows (111)-silicon substrate 11, epitaxial, partially relaxed layer 12 of silicon-germanium, layer 13 of (111)-silicon under tension, and layer 14 of silicon oxide. Tension in layer 13 can be understood as resulting from layer 12 having an in-plane lattice constant which is slightly greater than that of bulk silicon. Equilibrium lattice constant of the silicon-germanium layer 12 depends directly on germanium content. In-plane lattice constant depends directly on the degree of relaxation which, in turn, is a function of layer thickness. While a thick, completely relaxed layer of Ge_{.5}SI_{.5} has a lattice constant which is approximately 2 percent greater than that of silicon, tension resulting from as little as 0.1 percent mismatch can be effective for inducing desired reconstruction in silicon layer 13. In accordance with this embodiment of the invention, a 5 x 5 reconstruction is present in an interface layer of silicon layer 13 as well as in at least a sub-layer of oxide layer 14 adjoining silicon layer 13.

Exemplary manufacture of this structure including a 5 x 5 reconstruction is conveniently effected by molecular beam epitaxy which, while more commonly associated with the manufacture of Group III-V semiconductor devices, is also applicable in (mixed) Group IV device technology. (For a survey of this field see, e.g., J. E. Bean, ed., Silicon Molecular Beam Epitaxy, Proceedings Vol. 85-7, Electronics Division, The Electrochemical Society, Inc.) By means of molecular beam epitaxy, silicon-germanium layer 12 is deposited on substrate 11, silicon and germanium being evaporated separately by means of electron-beam guns. In the case of germanium, evaporation by means of an effusion cell is also practicable. Silicon layer 13 is deposited by continued electron-beam evaporation. Silicon oxide layer 14 may be the result of oxidation in an oxygen-containing ambient such as, e.g., air (growth of a "native" oxide); alternatively, silicon oxide may be deposited, e.g., by chemical vapor deposition using a precursor such as, e.g., tetraethoxysilane (TEOS) or, for preferred low-temperature deposition, diacetoxyditeriarybutoxysilane (DADBS). Oxide deposition may be used also to deposit additional silicon oxide on a layer of native oxide.

The presence of 5 x 5 reconstruction in silicon layer 13 can be attributed to tension in layer 13, such tension being a function of the presence of the underlying partially relaxed silicon-germanium layer 12. Since silicon-germanium also exhibits 5 x 5 reconstruction, it is even possible that layer 13 may be omitted, 5 x 5 reconstruction being realized in an oxide layer 14 as a result of direct contact with layer 12.

Formation of 5 x 5 structure is favored at relatively low temperatures of deposition of a silicon-germanium layer; preferred in this respect are temperatures not exceeding 600 degrees C. In cases where higher deposition temperatures are used, a subsequent step of annealing at lower temperatures can be used to form 5 x 5 structure in a layer as already deposited. Preferred annealing temperatures are in a range of 200 to 400 degrees C.

FIG. 2 shows silicon substrate 21 which is doped p-plus except for source region 22 and drain region 23 which are doped n-plus. A channel region 24 is covered with a gate oxide layer 25, and field oxide regions 26 adjoin the source region 22 and the drain region 23. A contact metallization layer 27 is on the source region 22, a contact metallization layer 28 is on the drain region 23, and a gate metallization layer 29 is on the gate oxide layer 25. Diffusion barrier metallization layers 30 and 31 are on the contact metallization layers 27 and 28, respectively. A first insulating oxide layer 32 insulates the field oxide regions 26 as well as the gate metallization layer 29. A first interconnect metallization 33 is in contact with the diffusion barrier metallization layers 30 and 31 and with the gate metallization layer 29. A second insulating oxide layer 34 is on the interconnect metallization 33, and a second interconnect metallization layer 35 on the second insulating oxide layer 34 is in contact with the first interconnect metallization layer 33 through openings in the second insulating oxide layer 34.

In accordance with the invention, layer 25 has ordered structure at the interface with region 24 and, as a result of such order, a high-quality interface having few defects (traps) can be obtained. As indcated by the presence of buried layer 36 of relaxed silicon-germanium, such ordered structure is induced by tensile strain in channel region 24. Benefits of the invention can also be realized at the interface between substrate 21 and field oxide 26.

As a further possibility, order can be induced even in the absence of strain, e.g., when a sufficiently regular (100)-silicon surface is oxidized. Suitable in this respect are surfaces which are atomically smooth, or which are free - or sufficiently free - of monolayers steps. Specifically, since grain size of deposited silicon oxide is determined by the distance between monolayer steps, the spacing between such steps is preferably maximized. On the other hand, steps two monolayers high do not result in grain boundaries because lattice continuity of an oxide having two-fold symmetry is maintained across two-monolayer steps of silicon which has four-fold symmetry.

By annealing of an approximately oriented (100)-silicon surface, it is possible to essentially monolayer steps by combining them into steps two monolayers high as may be observed by reflection high-energy electron diffraction. Preferred annealing conditions depend on the degree and direction of substrate misorientation; typically, for commercially available substrates, preferred annealing is under conditions of ultra-high vacuum at a temperature of approximately 800-1000 degrees C for a duration of approximately 30 minutes.

The presence of steps may actually offer advantages, e.g., in the case of growth of Group IV element or alloy layers where the growth mechanism involves lateral diffusion of impinging atoms to a ledge. This aspect may be particularly advantageous in structures such as, e.g., ultra-thin superlattices where growth is essential.

In other applications, electronics properties other than passivation, and electronic effects such as, e.g., tunneling may play a role at ordered semiconductor/dielectric interfaces in accordance with the invention. Also, ordered interfaces may have higher dielectric strength, permitting the application of stronger electric fields without dielectric breakdown. Among contemplated further applications are structures in which one or several additional layers are deposited on a dielectric layer, for example, crystalline silicon may be deposited on an ordered layer of silicon oxide so as to form, together with the underlying silicon, an ultra-thin, highly insulating capacitor and, possibly, other three-dimensional integrated structures.

The following examples serve to illustrate the invention in the case of silicon devices.

### Example 1.

A(111)-silicon substrate was cleaned, and a silicon epitaxial layer having a thickness of approximately 100 nanometers was desposited by molecular beam epitaxy at a temperature of approximately 750 degrees C. Surface structure was monitored in-situ by reflection high-energy electron diffraction and observed to be a 7 x 7 reconstruction. On the silicon layer a Ge_{0.5}SI_{0.5} layer having a thickness of approximately 8 nanometers was deposited at a temperature of approximately 500 degrees C. Reflection high-energy electron diffraction examination of this layer showed the 5 x 5 pattern typical of this alloy. On the silicon-germanium layer, a layer of silicon having a thickness of approximately 15 nanometers was deposited. This layer also was found to have 5 x 5 structure. The sample was removed from the molecular beam epitaxy chamber and left standing in air for a period of several weeks. The oxidized sample was polished from the back and chemically etched to perforation in HF:HNO₃. Examination by transmission electron diffraction yielded a pattern as diagrammatically shown in FIG. 3, indicative of 5 x 5 reconstruction.

### Example 2.

The steps described above in Example 1 were repeated except that a 120-nanometer layer of Ge_{.25}SI_{.75} was deposited instead of the layer of Ge_{0.5}SI_{0.5}. A 12.5-nanometer layer of silicon with native oxide showed essentially the same structure as the layer of Example 1.

### Example 3.

A sample was grown similar to Example 1, but deposition was at a higher temperature. The deposited (111)-silicon layer exhibited a 7 x 7 reconstruction in the molecular beam epitaxy chamber. Transmission electron diffraction examination of this sample, after thinning at room temperature, showed that 7 x 7 structure disappears upon exposure of the ordered silicon surface to air and that surface structure reverts to bulk structure. However, after annealing the thinned sample at a temperature of approximately 250 degrees C a 5 x 5 reconstruction was observed. This surface structure remains stable in air and, indeed, induces 5 x 5 reconstruction of the oxide layer.

### Example 4.

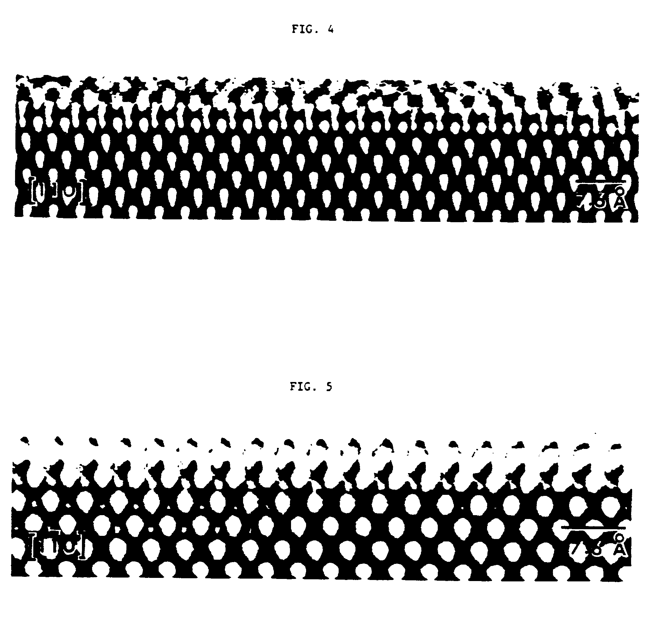

Molecular beam epitaxy was used to grow a 200-nanometer layer of silicon on a p-type, high-resistivity (100)-silicon substrate under ultra-high-vacuum conditions. The sample was removed from the vacuum chamber and allowed to form a native oxide having a thickness of approximately 1.5 nanometer. A plan-view sample was prepared by chemically etching away the substrate, and the prepared sample was examined in a transmission electron microscope operating at approximately 120 kV, with the electron beam essentially parallel to the [001]-direction. A cross-sectional sample was made by ion-milling to perforation, and the sample was then examined in a high-resolution transmission electron microscope operating at approximately 400 kV, with the beam parallel first to the [110]-direction, and then parallel to the [110]-direction. Respective images are as shown in FIG. 4 and 5. An ordered, 0.5-nanometer-thick layer of silicon oxide on silicon is inferred.

### Example 5.

A sample was prepared as described in Example 4 above, except that oxidation was by annealing in dry oxygen at a temperature of approximately 800 degrees C for approximately 30 minutes, resulting in an 8-nanometer oxide layer. Essentially the same features were observed as those shown in FIG. 4 and 5.

## Claims

1. A Group IV semiconductor device comprising (i) a Group IV semiconductor material and (ii) a layer (25) comprising a dielectric compound of a constituent element of said Group IV semiconductor material;
said layer having an interface with at least a region of a surface of said semiconductor material;
CHARACTERIZED IN THAT, at said interface, at least a monolayer of said dielectric compound is in an ordered state.

2. The device according to claim 1,
CHARACTERIZED IN THAT
said ordered state is induced by an ordered state of said Group IV semiconductor material at said interface.

3. The device of claim 2 in which said ordered state of said Group IV semiconductor material is induced by strain.

4. The device according to claim 2,
CHARACTERIZED IN THAT
said semiconductor material has a surface which, in the absence of surface stain, is compatible with said ordered state of said dielectric compound, said dielectric compound being on said surface in said ordered state.

5. The device according to claim 4,
CHARACTERIZED IN THAT
said surface of said Group IV semiconductor material being atomically smooth.

6. The device according to claim 4,
CHARACTERIZED IN THAT
said Group IV semiconductor material consists essentially of silicon and said surface is essentially a (100)-surface.

7. The device according to claim 6,
CHARACTERIZED IN THAT
said surface being essentially free of surface steps having monolayer height.

8. The device according to claim 7,
CHARACTERIZED IN THAT
surface comprising steps two monolayers high.

9. The device according to claim 1,
CHARACTERIZED IN THAT
said Group IV semiconductor material consists essentially of silicon.

10. The device according to claim 9,
CHARACTERIZED IN THAT
said dielectric compound is silicon oxide.

11. The device according to claim 10,
CHARACTERIZED IN THAT
said ordered state is a 5 × 5 reconstruction as determined by transmission electron diffraction examination.

12. The device according to claim 11,
CHARACTERIZED IN THAT
said device comprises an at least partially relaxed layer (36) in contact with silicon.

13. The device according to claim 12,
CHARACTERIZED IN THAT
said relaxed layer consists essentially of germanium-silicon.

14. A method for making a device according to claim 3, comprising the following steps:
(i) a step which results in the production of said strain in at least a portion of a surface layer of said Group IV semiconductor material, and subsequently
(ii) a step which results in the formation of said layer (25) comprising said dielectric compound whereby said interface is formed in at least a region of said portion of a surface layer of said Group IV semiconductor material,
whereby at least a monolayer of said dielectric compound at said interface is in said ordered state.

15. The method according to claim 1,
CHARACTERIZED BY
producing said strain
(a) by deposition of said Group IV semiconductor material on an at least partially relaxed layer or (b) by annealing.

16. The method according to claim 14,
CHARACTERIZED BY
forming said dielectric compound at least in pan by native growth or at least in part by deposition, or both.

## Patentansprüche

1. Gruppe-IV-Halbleiterbauelement, das (i) aus einem Gruppe-IV-Halbleitermaterial und (ii) einer Schicht (25) besteht, die eine dielektrische Verbindung aus einem anteiligen Element aus dem Gruppe-IV-Halbleitermaterial umfaßt;
wobei die Schicht eine Grenzfläche mit mindestens einem Bereich einer Oberfläche des Halbleitermaterials aufweist;
dadurch gekennzeichnet, daß sich an der Grenzfläche mindestens eine Monoschicht aus der dielektrischen Verbindung in einem geordneten Zustand befindet.

2. Bauelement nach Anspruch 1, dadurch gekennzeichnet, daß der geordnete Zustand durch einen geordneten Zustand des Gruppe-IV-Halbleitermaterials an der Grenzfläche induziert wird.

3. Bauelement nach Anspruch 2, bei dem der geordnete Zustand des Gruppe-IV-Halbleitermaterials durch Spannung induziert wird.

4. Bauelement nach Anspruch 2, dadurch gekennzeichnet, daß das Halbleitermaterial eine Oberfläche aufweist, die bei Fehlen von Oberflächenspannung mit dem geordneten Zustand der dielektrischen Verbindung vereinbar ist, wobei sich die dielektrische Verbindung in dem geordneten Zustand auf der Oberfläche befindet.

5. Bauelement nach Anspruch 4, dadurch gekennzeichnet, daß die Oberfläche des Gruppe-IV-Halbleitermaterials atomar glatt ist.

6. Bauelement nach Anspruch 4, dadurch gekennzeichnet, daß das Gruppe-IV-Halbleitermaterial im wesentlichen aus Silizium besteht und die Oberfläche im wesentlichen eine (100)-Oberfläche ist.

7. Bauelement nach Anspruch 6, dadurch gekennzeichnet, daß die Oberfläche im wesentlichen frei von Oberflächenstufen mit Monoschichthöhe sind.

8. Bauelement nach Anspruch 7, dadurch gekennzeichnet, daß die Oberfläche Stufen umfaßt, die zwei Monoschichten hoch sind.

9. Bauelement nach Anspruch 1, dadurch gekennzeichnet, daß das Gruppe-IV-Halbleitermaterial im wesentlichen aus Silizium besteht.

10. Bauelement nach Anspruch 9, dadurch gekennzeichnet, daß die dielektrische Verbindung Siliziumoxid ist.

11. Bauelement nach Anspruch 10, dadurch gekennzeichnet, daß der geordnete Zustand eine durch Untersuchung der Transmissionselektronenbeugung bestimmte 5x5-Rekonstruktion ist.

12. Bauelement nach Anspruch 11, dadurch gekennzeichnet, daß das Bauelement eine mindestens teilweise entspannte Schicht (36) umfaßt, die mit Sililzium in Kontakt steht.

13. Bauelement nach Anspruch 12, dadurch gekennzeichnet, daß die entspannte Schicht im wesentlichen aus Germanium-Silizium besteht.

14. Verfahren zur Herstellung eines Bauelements nach Anspruch 3, mit den folgenden Schritten:
(i) ein Schritt, der in der Produktion der Spannung in mindestens einem Teil einer Oberflächenschicht des Gruppe-IV-Halbleitermaterials resultiert, und danach
(ii) einen Schritt, der in der Bildung der die dielektrische Verbindung umfassenden Schicht (25) resultiert, wodurch die Grenzfläche in mindestens einem Gebiet des Teils einer Oberflächenschicht des Gruppe-IV-Halbleitermaterials gebildet wird,
wodurch sich mindestens eine Monoschicht der dielektrischen Verbindung an der Grenzfläche in dem geordneten Zustand befindet.

15. Verfahren nach Anspruch 1, gekennzeichnet durch das Produzieren der Spannung
(a) durch Abscheiden des Gruppe-IV-Halbleitermaterials auf einer mindestens teilweise entspannten Schicht oder (b) durch Tempern.

16. Verfahren nach Anspruch 14, gekennzeichnet durch Bilden der dielektrischen Verbindung mindestens teilweise durch eigenes Aufwachsen oder mindestens teilweise durch Abscheiden oder durch beides.

## Revendications

1. Dispositif à semi-conducteur de groupe IV comprenant (i) une matière semi-conductrice de groupe IV et (ii) une couche (25) comprenant un composé diélectrique d'un élément constitutif de ladite matière semi-conductrice de groupe IV ;
ladite couche ayant une interface avec au moins une zone d'une surface de ladite matière semi-conductrice ;
CARACTERISE EN CE QUE, au niveau de ladite interface, au moins une mono-couche dudit composé diélectrique est dans un état ordonné.

2. Dispositif selon la revendication 1,
CARACTERISE EN CE QUE
ledit état ordonné est induit par un état ordonné de ladite matière semi-conductrice de groupe IV au niveau de ladite interface.

3. Dispositif selon la revendication 2, dans lequel ledit état ordonné de ladite matière semi-conductrice de groupe IV est induit par contrainte.

4. Dispositif selon la revendication 2,
CARACTERISE EN CE QUE
ladite matière semi-conductrice a une surface qui, en l'absence de contrainte de surface, est compatible avec ledit état ordonné dudit composé diélectrique, ledit composé diélectrique étant sur ladite surface dans ledit état ordonné.

5. Dispositif selon la revendication 4,
CARACTERISE EN CE QUE
ladite surface de ladite matière semi-conductrice de groupe IV est atomiquement lisse.

6. Dispositif selon la revendication 4,
CARACTERISE EN CE QUE
ladite matière semi-conductrice de groupe IV consiste essentiellement en silicium et ladite surface est essentiellement une surface (100).

7. Dispositif selon la revendication 6,
CARACTERISE EN CE QUE
ladite surface est essentiellement dépourvue d'échelons de surface ayant une hauteur mono-couche.

8. Dispositif selon la revendication 7,
CARACTERISE EN CE QUE
la surface comprend des échelons d'une hauteur de deux mono-couches.

9. Dispositif selon la revendication 1,
CARACTERISE EN CE QUE
ladite matière semi-conductrice de groupe IV consiste essentiellement en silicium.

10. Dispositif selon la revendication 9,
CARACTERISE EN CE QUE
ledit composé diélectrique est de l'oxyde de silicium.

11. Dispositif selon la revendication 10,
CARACTERISE EN CE QUE
ledit état ordonné est une reconstruction 5 x 5 telle que déterminée par examen de diffraction électronique à transmission.

12. Dispositif selon la revendication 11,
CARACTERISE EN CE QUE
ledit dispositif comprend une couche au moins partiellement relaxée (36) en contact avec le silicium.

13. Dispositif selon la revendication 12,
CARACTERISE EN CE QUE
ladite couche relaxée consiste essentiellement en germanium-silicium.

14. Procédé de fabrication d'un dispositif selon la revendication 3, comprenant les étapes suivantes :
(i) une étape qui résulte en la production de ladite contrainte dans au moins une partie d'une couche de surface de ladite matière semi-conductrice de groupe IV, et ensuite
(ii) une étape qui résulte en la formation de ladite couche (25) comprenant ledit composé diélectrique par laquelle ladite interface est formée dans au moins une zone de ladite partie d'une couche de surface de ladite matière semi-conductrice de groupe IV,
par lequel au moins une mono-couche dudit composé diélectrique au niveau de ladite interface est dans ledit état ordonné.

15. Procédé selon la revendication 14,
CARACTERISE PAR
la production de ladite contrainte
(a) par dépôt de ladite matière semi-conductrice de groupe IV sur une couche au moins partiellement relaxée ou (b) par recuit.

16. Procédé selon la revendication 14,
CARACTERISE PAR
la formation dudit composé diélectrique au moins en partie par tirage natif ou au moins en partie par dépôt, ou les deux.
